# EUROPÄISCHE PATENTSCHRIFT

(11) **EP 0 929 936 B1**
(45) Veröffentlichungstag und Bekanntmachung des Hinweises auf die Patenterteilung: **21.03.2001**
(21) Anmeldenummer: 97912036.7
(22) Anmeldetag: 29.09.1997
(51) Int. Cl.: H03F 3/72, H03J 5/24

(54) **MEHRFACH-VORSTUFENSCHALTUNG FÜR FERNSEH-TUNER**
MULTIPLE PREAMPLIFIER CIRCUIT FOR A TELEVISION TUNER
CIRCUIT PREAMPLIFICATEUR MULTIPLE POUR DISPOSITIF D'ACCORD DE TELEVISION

(30) Priorität: 30.09.1996 DE 19640216
(43) Veröffentlichungstag der Anmeldung: 21.07.1999
(73) Patentinhaber: Infineon Technologies AG, 81669 München (DE)
(72) Erfinder: MUSIOL, Lothar, D-81735 München (DE); KUHN, Ralph, D-85591 Vaterstetten (DE)
(74) Vertreter: Zedlitz, Peter, Dipl.-Inf.
(86) Internationale Anmeldenummer: DE9702232
(87) Internationale Veröffentlichungsnummer: WO9815055

(56) Entgegenhaltungen:
- EP-A- 0 457 932
- EP-A- 0 457 934
- EP-A- 0 500 434
- US-A- 3 769 604

## Beschreibung

Die vorliegende Erfindung betrifft eine Mehrfach-Vorstufenschaltung für Fernseh-Tuner, mit mindestens einem eine Verstärkerstufe aufweisenden ersten Band und einem eine Verstärkerstufe aufweisenden zweiten Band.

Die über einen Frequenzbereich zwischen etwa 50 und 850 MHz ausgesandten Fernsehsignale werden zumeist in drei Bändern eines Fernseh-Tuners verarbeitet, nämlich einem UHF-Band, einem VHF-HF1-Band und einem VHF2-Band. Es ist aber auch möglich, das VHF1-Band und das VHF2-Band in einem einzigen VHF-Band zusammenzufassen, so daß die kostengünstigsten Tuner-Konzepte über insgesamt zwei Bänder verfügen.

Aus EP-A-0 457 932 ist eine Schaltungsanordnung zur Bereichsumschaltung in Tunern bekannt, bei welcher eine MOS-Tetrode als Verstärker verwendet wird. Die Source-Anschlüsse der MOS-Tetrode sind über einen Steuerschaltkreis zwischen den beiden Versorgungspotentialen 0 V und 5 V schaltbar. Abhängig vom angelegten Potential wird der gewünschte Bereich ausgewählt.

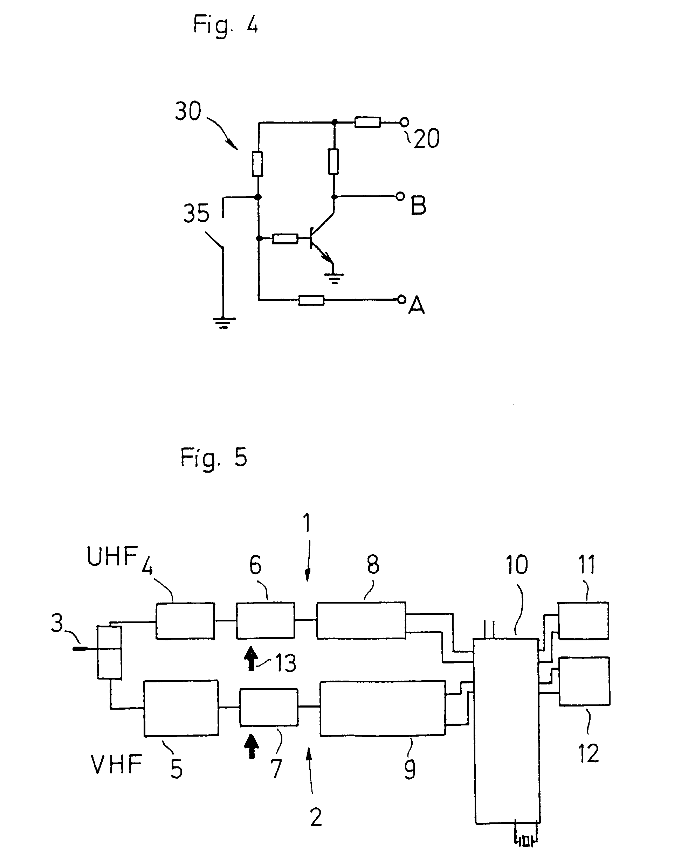

Ein Zweiband-Fernseh-Tuner ist ferner beispielsweise in Figur 5 gezeigt.
Der in Figur 5 dargestellte Fernseh-Tuner umfaßt ein UHF-Band 1 und ein VHF-Band 2. Abhängig von der Frequenz des gewünschten Fernsehkanals wird entweder das UHF- oder VHF-Band aktiviert (Bandumschaltung). Ein über eine Antenne 3 zugeführtes Fernsehsignal wird im Band 1 bzw. 2 jeweils zunächst einem Vorselektionskreis 4 bzw. 5 für eine Grobeinstellung zugeführt. Diesen Vorselektionskreisen 4 und 5 ist jeweils eine regelbare Verstärkerstufe 6 und 7 nachgeschaltet, in welchen die Fernsehsignale signalpegelabhängig verstärkt werden. Diese Verstärkerstufen werden mit Dual-Gate MOS-FETs realisiert. Diese Feldeffekttransistoren lassen sich gut an Resonanzkreise anpassen und sind beispielsweise in der EP-A-0 457 932 beschrieben.

Den Verstärkerstufen 6 und 7 sind Bandpaßfilter 8 und 9 nachgeschaltet, an deren Ausgang ein Tuner-IC 10 mit Oszillatoren 11, 12 den gewählten Kanal auf die Fernseh-Zeilenfrequenz umsetzt.

Den beiden Verstärkerstufen 6 und 7 sind jeweils Verstärkungssteuersignale zugeführt, was durch Pfeile 13 angedeutet ist, und sie werden vom Tuner-IC über eine Umschaltlogik 30 wahlweise eingeschaltet. Diese Funktionen erfordern einen erheblichen diskreten Bauteileaufwand.

Es ist **Aufgabe** der vorliegenden Erfindung, die bestehende Zwei-Band-Vorstufenschaltung für Fernseh-Tuner weiter zu vereinfachen, so daß sie mit insgesamt weniger Bauteilen auskommt und kompakter ausgeführt werden kann.

Zur Lösung dieser Aufgabe zeichnet sich eine Mehrfach-Vorstufenschaltung der eingangs genannten Art erfindungsgemäß dadurch aus, daß die Verstärkerstufe des ersten Bandes und die Verstärkerstufe des zweiten Bandes in einen für die beiden Bänder gemeinsamen Chip integriert sind, dem ein Bandumschaltsignal und ein Verstärkungssteuersignal zuführbar sind.

Bei der erfindungsgemäßen Mehrfach-Vorstufenschaltung sind also die beiden Verstärkerstufen der bestehenden Zwei-Band-Vorstufenschaltung auf einem Chip untergebracht, so daß für beide Bänder Schaltungsteile und Gehäuseanschlüsse gemeinsam genutzt werden können. Es sei angemerkt, daß auch die Verstärkerstufen von mehr als zwei Bändern gegebenenfalls in diesem einen Chip integriert sein können.

Eine erste Stufe kann dabei dem UHF-Band zugeordnet sein, während die zweite Stufe im VHF-Band arbeitet.

Der Chip enthält also für jedes Band eine MOS-FET-Verstärkerstufe, wobei alle MOS-FET-Verstärkerstufen eines Chips durch nur ein Bandumschaltsignal von einem Tuner-IC umschaltbar sind. Außerdem weist der Chip mindestens eine Arbeitspunkt-einstellschaltung und eine Umschaltlogik auf. Die Arbeitspunkteinstellschaltung besteht dabei aus einer Stromspiegelschaltung mit einem zur MOS-FET-Verstärkerstufe liegenden Referenztransistor. Das Bandumschaltsignal ist der Umschaltlogik zugeführt, während das Verstärkungssteuersignal einem zweiten Gate jeder MOS-FET-Verstärkerstufe eingespeist ist, deren erstes Gate mit einem Eingangssignal beaufschlagt ist.

Der Chip kann beispielsweise in einem SMD-Gehäuse untergebracht sein (SMD = Surface Mounted Device).

Nachfolgend wird die Erfindung anhand der Zeichnungen näher erläutert.

Es zeigen:
- Fig. 1: ein Blockschaltbild eines Fernseh-Tuners mit der erfindungsgemäßen Mehrfach-Vorstufenschaltung,
- Fig. 2: ein Schaltbild eines ersten Ausführungsbeispiels der erfindungsgemäßen Vorstufenschaltung,
- Fig. 3: ein Schaltbild eines zweiten Ausführungsbeispiels der erfindungsgemäßen Vorstufenschaltung,
- Fig. 4: ein Schaltbild einer Variante der Umschaltlogik zu dem Ausführungsbeispiel von Fig. 3,
- Fig. 5: ein Blockschaltbild eines Fernseh-Tuners mit einer bestehenden Zwei-Band-Vorstufenschaltung, und
- Fig. 6 und 7: jeweils eine weitere Variante der Ausführungsbeispiele gemäß Fig. 3 bzw. 4.

Die Figur 5 ist bereits eingangs erläutert worden. In den Figuren werden für einander entsprechende Bauteile die gleichen Bezugszeichen verwendet.

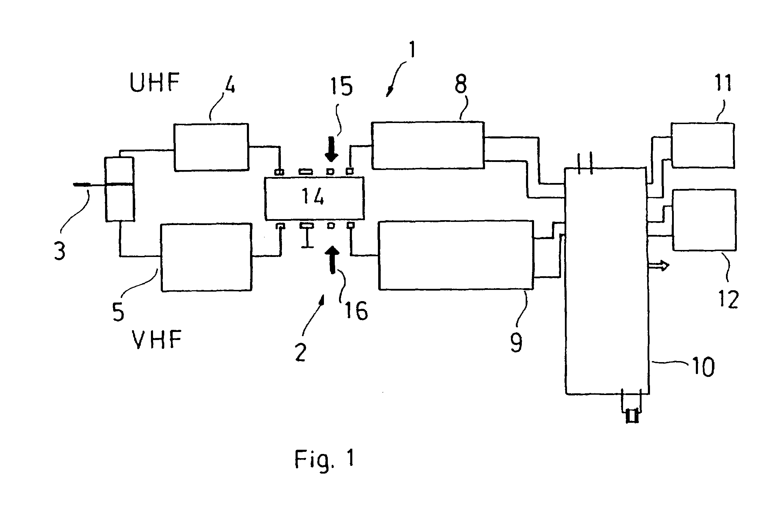

Wie in der Figur 1 gezeigt ist, sind bei der erfindungsgemäßen Mehrfach-Vorstufenschaltung die beiden Verstärkerstufen 6 und 7 der bestehenden Vorstufenschaltung zu einer Verstärkerstufe 14 integriert, die in einem Chip mit beispielsweise einem SMD-Gehäuse untergebracht ist. Dieser Verstärkerstufe 14 sind ein Bandumschaltsignal (Pfeil 15) und ein Verstärkungssteuersignal (Pfeil 16) zuführbar. Mit Hilfe des Bandumschaltsignales (Pfeil 15) ist das gewünschte Band, also das UHF-Band 1 oder das VHF-Band 2, einschaltbar, während mit dem Verstärkungssteuersignal die Verstärkung einzustellen ist.

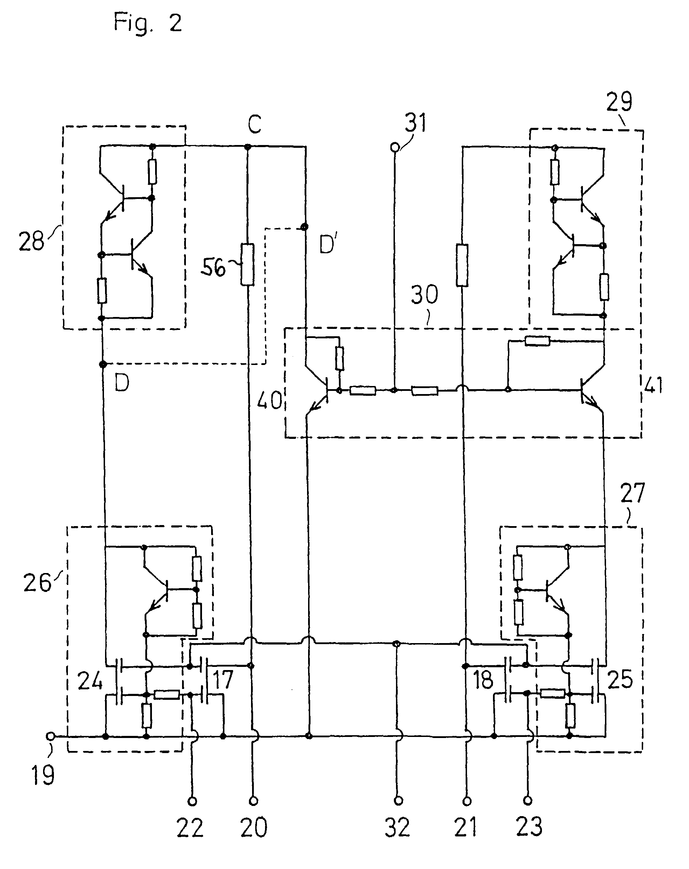

Figur 2 zeigt den Aufbau der Verstärkerstufe 14 in Einzelheiten. Wie bei der bestehenden Zwei-Band-Vorstufenschaltung weist auch die Verstärkerstufe 14 ähnlich zu der Verstärkerstufe 6 oder der Verstärkerstufe 7 Verstärker-MOS-FETs 17, 18 auf, deren Source-Drain-Strecken zwischen einem Bezugspotential 19 und einem ersten beziehungsweise zweiten Ausgang 20 beziehungsweise 21 liegen. Das erste Gate des Verstärker-MOS-FETs 17 beziehungsweise 18 ist mit einem ersten beziehungsweise zweiten Eingang 22 beziehungsweise 23 verbunden.

In Spiegelschaltung zu den Verstärker-MOS-FETs 17 beziehungsweise 18 liegt jeweils ein Referenztransistor 24 beziehungsweise 25, der viel kleiner dimensioniert ist als der Verstärker-MOS-FET 17 beziehungsweise 18. Fließt beispielsweise durch den Verstärker-MOS-FET 17 ein Strom von 10 mA, so führt der Referenztransistor 24 einen Strom von lediglich beispielsweise 0,1 mA.

Den Referenztransistoren 24 und 25 sind jeweils die Hilfsglieder 26, 27 und Stromquellenschaltungen 28, 29 vorgeschaltet. Die Stromquellenschaltungen 28, 29 versorgen jeweils über die Referenztransistoren 24 und 25 in der Stromspiegelschaltung die Verstärker-MOS-FETs 17 beziehungsweise 18. Diese Anordnung dient zur Arbeitspunkteinstellung.

Zum Umschalten zwischen den beiden Bändern beziehungsweise zwischen dem ersten Eingang 22 sowie dem ersten Ausgang 20 einerseits und dem zweiten Eingang 23 sowie dem zweiten Ausgang 21 andererseits dient eine Umschaltlogik 30, der über einen Anschluß 31 das Umschaltsignal zuführbar ist. Diese Umschaltlogik 30 weist insbesondere zwei Transistoren 40, 41 auf, die so geschaltet sind, daß sie jeweils nur einen Verstärker-MOS-FET beziehungsweise ein Band wirksam werden lassen können. Die gesteuerte Strecke des ersten Transistors 40 verbindet an einem Anschlußpunkt C, der über einen Widerstand 56 auch am ersten Ausgang 20 liegt, den eingangsseitigen Anschluß der ersten Stromquellenschaltung 28 mit dem Bezugspotential 19. Außerdem sind jeweils Kollektor und Basis der Transistoren 40, 41 verbunden.

Das zweite Gate der Verstärker-MOS-FETs 17 beziehungsweise 18 ist mit einem Anschluß 32 für das Verstärkungssteuersignal verbunden.

Die Umschaltlogik ist so ausgelegt, daß das am Anschluß 31 zuführbare Umschaltsignal von einem Schaltelement mit offenem Kollektorausgang angesteuert werden kann. Bekanntlich ist das Signal an einem derartigen offenen Kollektorausgang Null Volt im Zustand "geschlossen" des Schaltelements. Im Zustand "offen" des Schaltelements ist der Ausgang hochohmig.

Die Umschaltlogik arbeitet folgendermaßen. Wenn der Anschluß 31 mit Null Volt beaufschlagt ist, liegt an beiden Steuereingängen der Transistoren 40, 41, die gemeinsam mit dem Anschluß 31 verbunden sind, entsprechend Null Volt an und beide Transistoren 40, 41 sperren. Das hat zur Folge, daß das Signal am eingangsseitigen Anschlußpunkt C der ersten Stromquellenschaltung 28 wirksam ist und die erste Stromquellenschaltung 28 die erste Arbeitspunkt-Einstellschaltung 24 beaufschlagt.

Da der zweite Transistor 41 am Ausgang der zweiten Stromquellenschaltung 29 liegt, unterbricht er die Verbindung zwischen der zweiten Stromquellenschaltung 29 und der zweiten Arbeitspunkt-Einstellschaltung 25, wenn Null Volt am Anschluß 31 anliegt. Damit arbeitet das erste Hilfsglied 26 und das zweite Hilfsglied 27 ist inaktiv.

Die Umschaltung erfolgt, wenn der Anschluß 31 hochohmig ist. Dann sind der erste und zweite Transistor 40, 41 leitend. Das hat einerseits zur Folge, daß der eingangsseitige Anschlußpunkt C der ersten Stromquellenschaltung 28 über die gesteuerte Strecke des ersten Transistors 40 kurzgeschlossen ist und damit die erste Stromquellenschaltung ausgeschaltet ist. Damit ist auch das erste Hilfsglied 26 inaktiv.

Andererseits stellt der zweite Transistor 41 die Verbindung von der zweiten Stromquellenschaltung 29 zum Referenztransistor 25 des Hilfsgliedes 27 her, so daß dieses aktiv ist.

Alternativ zu der in Fig. 2 dargestellten Verbindung des ersten Transistors 40 der Umschaltlogik 30 mit dem eingangsseitigen Anschlußpunkt C der ersten Stromquellenschaltung 28 könnte das Abschalten des ersten Hilfsglieds 26 auch dadurch erfolgen, daß der Ausgang D der ersten Stromquellenschaltung 28 mit der gesteuerten Strecke des ersten Transistors 40 verbunden ist, wie es durch die gestrichelte Linie C-C' angedeutet ist.

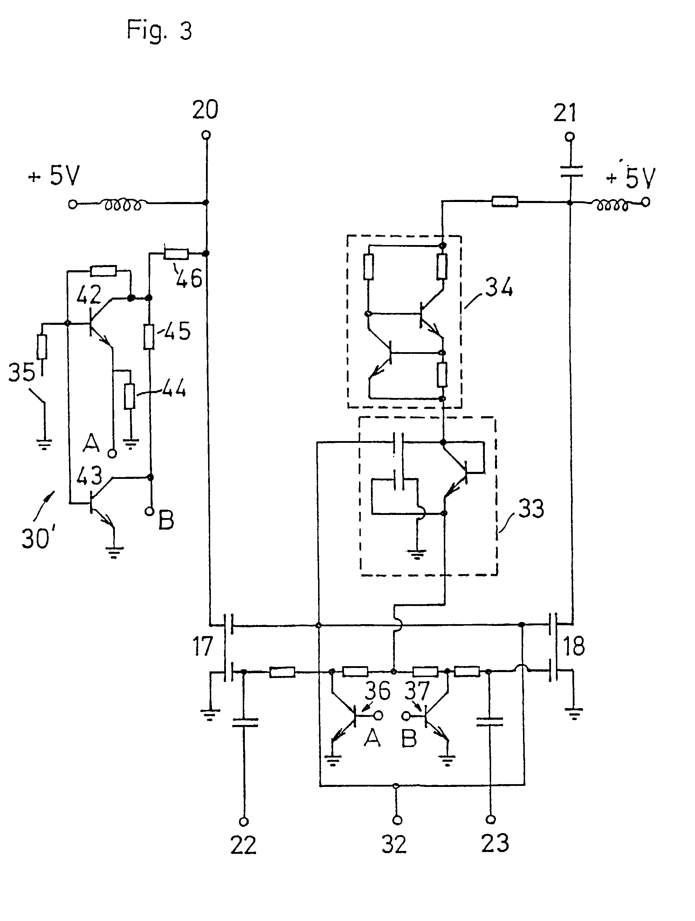

Es liegen beim Ausführungsbeispiel der Figur 2 somit zwei Arbeitspunkt-Einstellschaltungen 24, 26, 28 beziehungsweise 25, 27, 29 vor. Es wäre nun wünschenswert, wenn diese Arbeitspunkt-Einstellschaltungen in einer Schaltung zusammengefaßt werden könnten. Ein Ausführungsbeispiel hierfür ist in den Figuren 3 und 4 gezeigt. Die Figur 4 zeigt dabei eine Variante des linken oberen Schaltungsteiles der Schaltung von Figur 3. Dabei sind die Anschlußpunkte "A" und "B" jeweils mit den Anschlußpunkten "A" und "B" an den Basen der Bipolartransistoren zu verbinden.

In der Schaltung von Figur 3 ist beiden Verstärker-MOS-FETs 17 und 18 als Referenztransistor eine Tetrode mit Hilfsglied 33 zugeordnet, der eine Stromquelle 34 vorgeschaltet ist. Die Umschaltlogik 30, zu der auch die Bipolartransistoren 36 und 37 gehören, wird durch ein Schaltsignal 35 gesteuert, das den jeweiligen Verstärker-MOS-FET 17 beziehungsweise 18 mit seinem Kanal ein- beziehungsweise ausschaltet.

Die Umschaltung mit der Schaltung gemäß Fig. 3 arbeitet folgendermaßen. Wenn am offenen Kollektorausgang 35 ein Signal Null Volt anliegt, ist der Transistor 42 leitend und der Anschluß A des Transistors 42 bewirkt ein Durchschalten des Bipolartransistors 36. Das führt dazu, daß die am Verstärker-MOS-FET 17 anliegende Spannung kurzgeschlossen wird.

Andererseits liegt bei durchgeschaltetem Transistor 43 der Anschlußpunkt B auf Null Volt, was dazu führt, daß der Bipolartransistor 37 sperrt, so daß der Verstärker-MOS-FET 18 vom Hilfsglied 33 versorgt wird.

Bei offenen Eingang am Schalter 35 sind beide Transistoren 42, 43 gesperrt. Dann wird über den Widerstand 44 der Anschluß A auf Null Volt gelegt, während der Anschluß B über die Widerstände 45, 46 mit der Betriebsspannung von +5 Volt versorgt ist. Das führt dazu, daß die beiden Bipolartransistoren 36, 37 sich genau umgekehrt zu den vorstehend beschriebenen Zustand verhalten, d.h. der Bipolartransistor 36 ist gesperrt und der Bipolartransistor 37 ist leitend, was zu einer Umschaltung zwischen den Verstärker-MOS-FETs 17, 18 führt.

Die Variante der Figur 4 zeichnet sich dadurch aus, daß sie einen Transistor weniger als die Variante der Figur 3 benötigt.

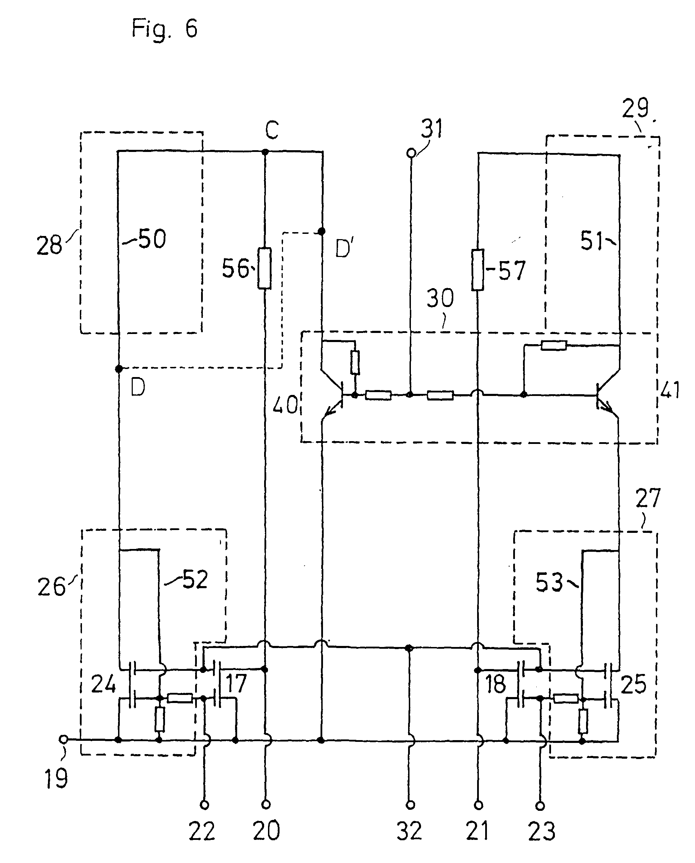

In den in Fig. 6 dargestellten Ausführungsbeispiel sind gleiche Teile wie in Fig. 2 mit den gleichen Bezugszeichen versehen. Die Schaltung unterscheidet sich von dem Beispiel gemäß Fig. 2 dadurch, daß die erste Stromquellenanordnung 28 lediglich aus einer die Anschlußpunkte C, D überbrückenden Leitung 50 besteht, die zusammen mit dem Widerstand 56 zwischen dem Eingang 20 und dem Anschlußpunkt C die Funktion einer Stromquelle hat. In gleicher Weise sind der Ein- und Ausgang der zweiten Stromquellenanordnung 29 durch eine Leitung 51 überbrückt, die mit Widerstand 57 in der Leitung zwischen Ausgang 21 und Eingang der Stromquellenanordnung 29 als Stromquelle wirkt.

Ferner sind in den Hilfsglieder 26, 27 Brücken 52 bzw. 53 vorhanden, die den Eingang und Ausgang der Referenztransistoren 24, 25 in der im einzelnen dargestellten Weise verbinden.

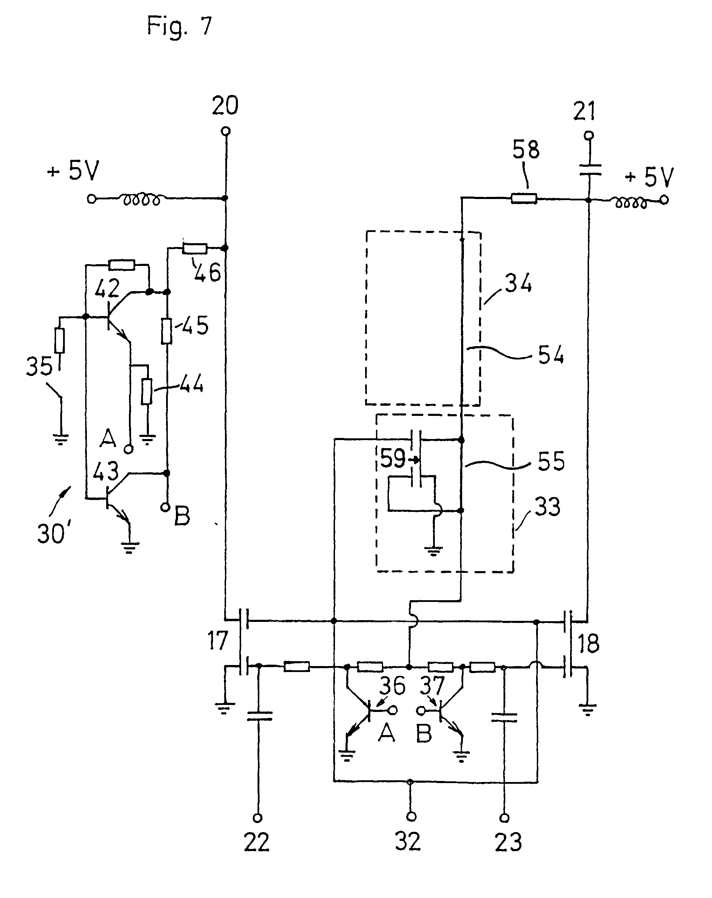

Bei dem in Fig. 7 dargestellten Ausführungsbeispiel, welches mit Ausnahme der nachfolgend beschriebenen Unterschiede dem Beispiel gemäß Fig. 3 entspricht, besteht die Stromquelle 34 aus einer Ein- und Ausgang überbrückenden Leitung 54, die mit einem vorgeschalteten Widerstand 58 die Stromquellenfunktion hat.

Beim Hilfsglied 33 sind Ein- und Ausgang des Referenztransistors 59 in der im einzelnen dargestellten Weise durch Leitung 55 überbrückt.

Anstelle der vorstehend beschriebenen Tetroden können alternativ auch Schaltelemente mit einer höheren Anzahl von Steuereingängen verwendet werden, z. B. Pentoden. Ebenso können statt der vorstehend beschriebenen bipolaren Transistoren auch MOS-FETs eingesetzt werden.

## Patentansprüche

1. Mehrfach-Vorstufenschaltung für Fernseh-Tuner, mit mindestens einem eine Verstärkerstufe aufweisenden ersten Band (1) und einem eine Verstärkerstufe aufweisenden zweiten Band (2),
**dadurch gekennzeichnet,**
daß die Verstärkerstufe des ersten Bandes (1) und die Verstärkerstufe des zweiten Bandes (2) in einen für die beiden Bänder (1, 2) gemeinsamen Chip (14) integriert sind, dem ein Bandumschaltsignal (31) und ein Verstärkungssteuersignal (32) zuführbar sind, daß der Chip (14) für jedes Band eine Verstärkerstufe mit einem Transistor (17, 18) enthält und alle Verstärkerstufen (17, 18) durch nur ein Bandumschaltsignal von einem Tuner-IC (10) umschaltbar sind, daß der Transistor (17, 18) mindestens einer Verstärkerstufe (17, 18) zusammen mit jeweils einem Referenztransistor (24, 25) eine Stromspiegelschaltung bildet, daß der Referenztransistor (24) der einen Verstärkerstufe (17) durch die gesteuerte Strecke eines Transistors (40, 36, 37) mit einem Bezugspotential verbindbar ist, um in Abhängigkeit vom Bandumschaltsignal die gesteuerte Strecke des Referenztransistors (24) der Verstärkerstufe (17) zu sperren oder zur Verbindung mit dem Bezugspotential durchzuschalten, und daß die andere Verstärkerstufe (18) dazu komplementär über das Bandumschaltsignal aktiviert oder deaktiviert wird.

2. Mehrfach-Vorstufenschaltung nach Anspruch 1,
**dadurch gekennzeichnet,**
daß ein Referenztransistor (25) der anderen Verstärkerstufe (18) mit dem Bezugspotential kurzgeschlossen wird.

3. Mehrfach-Vorstufenschaltung nach Anspruch 1 oder 2,
**dadurch gekennzeichnet,**
daß Steuereingänge (22, 23) der Verstärkerstufen (17, 18) mit dem Bezugspotential kurzgeschlossen werden.

4. Mehrfach-Vorstufenschaltung nach einem der Ansprüche 1 bis 3,
**dadurch gekennzeichnet,**
daß der Chip (14) außerdem mindestens eine Arbeitspunkteinstellschaltung (24, 26, 28; 25, 27, 29) und eine Umschaltlogik (30) enthält.

5. Mehrfach-Vorstufenschaltung nach Anspruch 4,
**dadurch gekennzeichnet,**
daß die Arbeitspunkteinstellschaltung (24, 26, 28; 25, 27, 29) aus einer Stromquelle (28, 29), Hilfsglied (26, 27) und dem in Stromspiegelschaltung zur betreffenden Verstärkerstufe liegenden Referenztransistor (24, 25) besteht.

6. Mehrfach-Vorstufenschaltung nach einem der Ansprüche 1 bis 5,
**dadurch gekennzeichnet,**
daß der Chip (14) in einem SMD-Gehäuse untergebracht ist.

## Claims

1. Multiple input stage circuit for television tuners, having at least a first band (1) having an amplifier stage and a second band (2) having an amplifier stage,
characterized
in that the amplifier stage of the first band (1) and the amplifier stage of the second band (2) are integrated in a chip (14), which is common to the two bands (1, 2) and to which a band switching signal (31) and a gain control signal (32) can be fed, in that the chip (14) contains, for each band, an amplifier stage having a transistor (17, 18) and all the amplifier stages (17, 18) can be switched over by just one band switching signal from a tuner IC (10), in that the transistor (17, 18) of at least one amplifier stage (17, 18) forms a current mirror circuit together with a respective reference transistor (24, 25), in that the reference transistor (24) of one amplifier stage (17) can be connected to a reference-earth potential through the controlled path of a transistor (40, 36, 37) in order, depending on the band switching signal, to turn off the controlled path of the reference transistor (24) of the amplifier stage (17) or to turn it on for connection to the reference-earth potential, and in that the other amplifier stage (18) is activated or deactivated complementarily to the former via the band switching signal.

2. Multiple input stage circuit according to Claim 1,
characterized
in that a reference transistor (25) of the other amplifier stage (18) is short-circuited to the reference-earth potential.

3. Multiple input stage circuit according to Claim 1 or 2,
characterized
in that control inputs (22, 23) of the amplifier stages (17, 18) are short-circuited to the reference-earth potential.

4. Multiple input stage circuit according to one of Claims 1 to 3,
characterized
in that the chip (14) additionally contains at least one operating-point setting circuit (24, 26, 28; 25, 27, 29) and a switching logic arrangement (30).

5. Multiple input stage circuit according to Claim 4,
characterized
in that the operating-point setting circuit (24, 26, 28; 25, 27, 29) comprises a current source (28, 29), auxiliary element (26, 27) and the reference transistor (24, 25) situated in a current mirror circuit with respect to the relevant amplifier stage.

6. Multiple input stage circuit according to one of Claims 1 to 5,
characterized
in that the chip (14) is accommodated in an SMD housing.

## Revendications

1. Circuit préamplificateur multiple pour bloc d'accord de télévision avec au moins une première bande (1) comportant un étage amplificateur et une deuxième bande (2) comportant un étage amplificateur
**caractérisé par le fait**
que l'étage amplificateur de la première bande (1) et l'étage amplificateur de la deuxième bande (2) sont intégrés dans une puce (14) commune aux deux bandes (1, 2), sur laquelle on peut appliquer un signal de commutation de bande (31) et un signal de commande d'amplification (32), par le fait que la puce (14) comporte, pour chaque bande, un étage amplificateur avec un transistor (17, 18) et que tous les étages amplificateurs (17, 18) peuvent être commutés, à l'aide d'un seul signal de commutation, par un circuit intégré d'accord (10), par le fait que le transistor (17, 18) d'au moins un étage amplificateur (17, 18) forme, en commun avec un transistor de référence respectif (24, 25), un circuit miroir de courant, par le fait que le transistor de référence (24) de l'un des étages amplificateurs (17) peut être connecté à un potentiel de référence à travers la ligne excitée d'un transistor (40, 36, 37) pour fermer, en fonction du signal de commutation de bande, la ligne excitée du transistor de référence (24) de l'étage amplificateur (17) ou l'ouvrir pour établir la liaison avec le potentiel de référence et par le fait que, d'une façon complémentaire, l'autre étage amplificateur (18) est activé ou désactivé à l'aide du signal de commutation de bande.

2. Circuit préamplificateur multiple pour bloc d'accord de télévision selon la revendication 1
**caractérisé par le fait**
qu'un transistor de référence (25) de l'autre étage amplificateur (18) est court-circuité avec le potentiel de référence.

3. Circuit préamplificateur multiple pour bloc d'accord de télévision selon la revendication 1 ou 2
**caractérisé par le fait**
que des entrées de commande (22, 23) des étages amplificateurs (17, 18) sont court-circuitées avec le potentiel de référence.

4. Circuit préamplificateur multiple pour bloc d'accord de télévision selon l'une des revendications 1 à 3
**caractérisé par le fait**
que la puce (14) comporte, par ailleurs, au moins un circuit de réglage du point de fonctionnement dynamique (24, 26, 28; 25, 27, 29) et une logique de commutation (30).

5. Circuit préamplificateur multiple pour bloc d'accord de télévision selon la revendication 4
**caractérisé par le fait**
que le circuit de réglage du point de fonctionnement dynamique (24, 26, 28; 25, 27, 29) est composée d'une source de courant (28, 29), d'un élément auxiliaire (26, 27) et du transistor de référence (24, 25) monté en circuit miroir de courant sur l'étage amplificateur correspondant.

6. Circuit préamplificateur multiple pour bloc d'accord de télévision selon l'une des revendications 1 à 5
**caractérisé par le fait**
que la puce (14) est logée dans un boîtier SMD (pour montage en surface).
